# EUROPÄISCHE PATENTSCHRIFT

(11) **EP 1 062 482 B1**
(45) Veröffentlichungstag und Bekanntmachung des Hinweises auf die Patenterteilung: **26.05.2004**
(21) Anmeldenummer: 99910155.3
(22) Anmeldetag: 26.01.1999
(51) Int. Cl.: G01D 4/00, G01R 21/133, G01D 5/39

(54) **EINHEIT ZUR BIDIREKTIONALEN ERFASSUNG UND ÜBERTRAGUNG VON DATEN ÜBER MODERNE KOMMUNIKATIONSNETZE**
UNIT FOR THE BIDIRECTIONAL DETECTION AND TRANSMISSION OF DATA VIA MODERN COMMUNICATION NETWORKS
UNITE DE DETECTION ET DE TRANSMISSION BIDIRECTIONNELLES DE DONNEES PAR L'INTERMEDIAIRE DE RESEAUX DE COMMUNICATION MODERNES

(30) Priorität: 11.03.1998 DE 19810335
(43) Veröffentlichungstag der Anmeldung: 27.12.2000
(73) Patentinhaber: PSG Fertigungs- und Prozessautomations GmbH, 84489 Burghausen (DE)
(72) Erfinder: MONSCHAU, Werner, D-53879 Euskirchen (DE); LORENZ, Ottmar, D-64653 Lorsch (DE); SCHNABEL, Arrigo, D-65791 Hofheim (DE)
(74) Vertreter: Keilitz, Wolfgang, Dipl.-Ing.
(86) Internationale Anmeldenummer: PCT/EP1999/000474
(87) Internationale Veröffentlichungsnummer: WO 1999/046564

(56) Entgegenhaltungen:
- DE-A- 4 321 037
- DE-A- 19 527 702
- GB-A- 2 297 663
- US-A- 4 940 976
- PATENT ABSTRACTS OF JAPAN vol. 018, no. 342 (E-1570), 28. Juni 1994 & JP 06 085848 A (MITSUBISHI ELECTRIC CORP), 25. März 1994

## Beschreibung

Die Erfindung betrifft ein elektronisches Gerät entsprechend dem Oberbegriff des Anspruchs 1, nämlich eine Vorrichtung zur automatischen Erfassung und bidirektionalen Übertragung von Daten, aufweisend eine erste Schnittstelle für den Dateneingang, eine zweite Schnittstelle für den Datenausgang sowie eine Übersetzungseinheit zur Bearbeitung der Daten, im folgenden auch als Ausleseeinheit bezeichnet.

Die in privaten Haushalten und in kleinen Gewerbebetrieben befindlichen Endgeräte, wie Gas-, Wasser- und Stromzähler werden i.d.R. einmal pro Jahr durch den zuständigen Energieversorger abgelesen. Der Energieversorger muß die Daten manuell von einem Mitarbeiter oder den Endverbraucher ablesen lassen. Diese Daten werden anschließend überwiegend manuell in einen Rechner übertragen, was viele Fehlerquellen in sich birgt. Im Rechner bilden sie die Grundlage der Abrechnung. Nach der Erfassung der Daten besitzt der Verbraucher nur sehr eingeschränkt die Möglichkeit, seinen spezifischen Verbrauch bezüglich Spitzenlast oder Schleichlast zu überprüfen, bzw. die Daten im Vergleich mit Vergangenheitswerten zu betrachten. Des weiteren sind Eingriffe der Energieversorgungsuntemehmen (EVU) in das aktuelle Konzept der Energieversorgung z. B. bzgl. Lastmanagement oder Mehrwertdienste praktisch unmöglich.

Endgeräte mit einer Schnittstelle für den Datenausgang auf Bus Basis werden zur Zeit bereits großtechnisch, z.B. in Großunternehmen, eingesetzt. Die Endgerätsignale werden nach einer Wandlung zu einer seriellen Schnittstelle (V24) weitergeleitet. Die Leitungsverbindung zwischen der seriellen Schnittstelle und dem Erfassungsrechner wird als Standleitung mit einer eigenen Telefonnummer geschaltet und ist somit mit hohen Kosten verbunden.

Geräte zur Vereinfachung der Übertragung von Daten vom Endgerät beim Verbraucher zum Energieversorgungsunternehmen sind bekannt.

So offenbart die GB 2 297 663 A ein entsprechendes System, mit dem Daten von einem Daten in einem ersten Schritt von einem Endgerät gelesen und zwischengespeichert werden können. In einem zweiten Schritt können die gespeicherten Daten über ein Telekommunikationssystem zu einem Sammelpunkt gesendet werden. Ein Durchgriff von dem Sammelpunkt auf das Endgerät findet bei diesem System nicht statt.

Aus der EP 0 450 829 A1 ist ein "intelligenter", programmierbarer, busfähiger Sensor bekannt, mit dem analoge Signale eingelesen, bearbeitet und gespeichert werden können.

Die DE 195 27 702 A1 offenbart einen busfähigen Computer zur Meßdatenverarbeitung für Durchlaufmengen- oder Wärmemengenmeßgeräte, mit dem die erfaßten Meßdaten zeitlich integriert werden können.. Eine Weiterleitung der Meßdaten ist nicht vorgesehen.
Aus der JP 06 085848 ist ein Verbindungselement eines Local or wide area Network (LAN und WAN) bekannt.

Weiter offenbart die DE 43 21 037 A1 eine Verfahren und eine Vorrichtung zur Erfassung und Übertragung von Meßwerten unter Verwendung eines informationsverarbeitenden Systems, welches von einem oder mehreren Wandlern stammende Signale erfaßt. Dabei findet eine fortlaufende informationstechnische Verarbeitung und Speicherung der Signale statt. Anschließend können die Daten drahtlos an eine weiterverarbeitende Stelle übermittelt werden. Ein direkter Zugriff der weiterverarbeitenden Stelle auf das Meßgerät ist nicht vorgesehen.

Schließlich ist aus der US 4,940,976 ein automatisiertes System zum Auslesen und Weiterleiten von Daten des Wasserverbrauchs in Haushalten bekannt. Die Verbrauchsdaten werden kontinuierlich ausgelesen und in einem Computer gespeichert, Von diesem Computer werden die gespeicherten Daten periodisch und drahtlos an eine Empfangsstation übertragen. Ein direkter Zugriff der Empfangsstation auf das Meßgerät findet nicht statt.

Vor diesem Stand der Technik lag der Erfindung die Aufgabe zugrunde, ein einfaches und kostengünstiges Gerät zu schaffen, das verschiedene Schnittstellen und Protokolle verwalten kann und damit eine variable, zeitnahe und automatische Auslesung von Daten, sowie eine Eingriffe zur Steuerung, ermöglicht. (z.B. Laststeuerung, Mehrwertdienste der EVU).

Diese Aufgabe wird erfindungsgemäß durch eine Vorrichtung der eingangs genannten Art gelöst, die dadurch gekennzeichnet ist,
- daß die erste Schnittstelle ein busfähiges System ist, an das ein oder mehrere Endgeräte anschließbar sind,
- daß die zweite Schnittstelle eine Schnittstelle zum ISDN-Telefonnetz oder zum Kabelfernsehnetz oder zur Satelitenübertragung ist und
- daß die Übersetzungseinheit aus einem oder mehreren programmierbaren Prozessoren besteht, die so verschaltet und programmiert sind, daß die Umsetzeinheit eine Datenanforderung über die zweite Schnittstelle erkennen kann und eine Datenanfrage an das busfähige System zur Weiterleitung an das oder jedes Endgerät senden kann und eine Datenantwort von dem oder jedem Endgerät über das busfähige System lesen, bearbeiten und an die zweite Schnittstelle weitergeben kann.

Gegenstand der Erfindung ist daher die Vorrichtung gemäß Anspruch 1.
Bevorzugte Ausgestaltungen sind in den abhängigen Ansprüchen offenbart. Es können auch einzelne oder mehrere dieser Ausgestaltungen jeweils für sich oder in Kombination Lösungen der erfindungsbegründenden Aufgabe darstellen und es sind auch die offenbarten Merkmale beliebig kombinierbar innerhalb des Umfangs der Ansprüche.

Die Erfindung bietet folgende Vorteile:

Durch die automatische Ablesung aller relevanter Daten, realisiert über eine ISDN Kopplung, entfällt die manuelle Vorort Ablesung durch einen Mitarbeiter des Energieversorgers oder den Endverbraucher. Ferner besteht für den Verbraucher die Möglichkeit zu jedem Zeitpunkt seine Verbrauchsdaten über einen Rechner einzusehen und z.B. mit Vergangenheitswerten zu vergleichen. Die Ausleseeinheit zeichnet sich zudem dadurch aus, daß für die Auslesung der Daten keine eigene Telefonleitung (Rufnummer) benötigt wird, sondern eine bereits bestehender ISDN-Anschluß mitbenutzt werden kann. Die erfindungsgemäße Vorrichtung kann mit Vorteil zur Übertragung der Daten über moderne Kommunikationsnetze, insbesondere über das Kabelfernsehnetz oder zur Satelitenübertragung, verwendet werden. Für den Anschluß an das Kabelfernsehnetz und zur Satelitenübertragung eignet sich als zweite Schnittstelle z.B. eine sogenannte Set-Top-Box wie sie in "Multimedia-Datenbanksysteme"
(http://wwwipd.ira.uka.de/~oosem/MM98/Schneider/folge.html#1) beschrieben ist.

Die neue Anordnung ermöglicht es, Zählerstände zeitnah und kostengünstig über ein ISDN Netz, ohne Schaltung einer eigenen Rufnummer (Standleitung), auszulesen.

Die Ausleseeinheit kann unterschiedliche Daten (Gas-, Wasser-, Stromverbräuche) flexibel, automatisch und zeitnah erfassen, umsetzen und weiterleiten. Durch die Benutzung der vorhandenen Infrastruktur ist eine geringe Verkabelung, leichte Zugänglichkeit und hohe Verfügbarkeit gewährleistet.

Diese Art der bidirektionalen Kommunikation ermöglicht völlig neue Perspektiven in der Energie- und Prozeßplanung, sowohl für den Endverbraucher, als auch für das EVU (schnelle und transparente Bearbeitung, Fernwartung, Überwachung und Leckagenortung, Last- und zeitabhängige Abrechnungsverfahren, Laststeuerung, zeitgerichtete Verbrauchsermittlung im liberalisierten Energiemarkt, etc.)

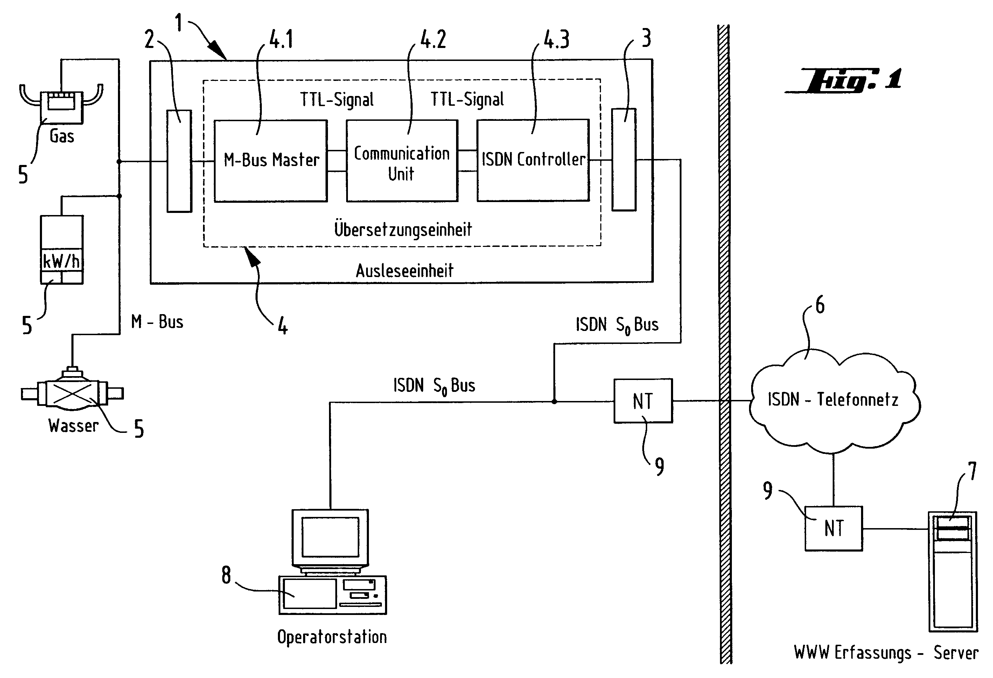

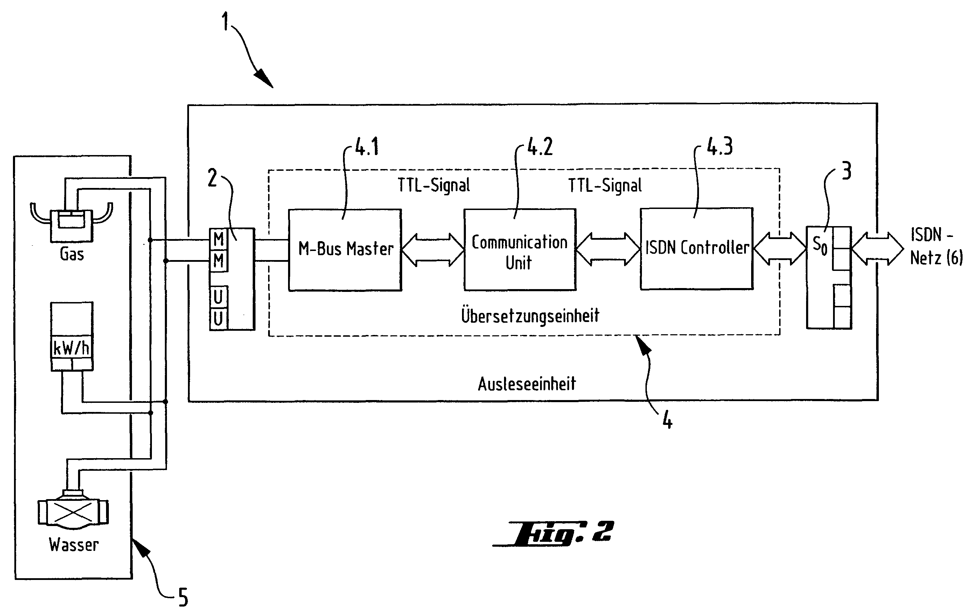

Im folgenden wird die erfindungsgemäße Vorrichtung anhand der in den Figuren 1 und 2 dargestellten Ausgestaltungsbeispiele näher beschrieben. Eine Beschränkung der Erfindung in irgend einer Weise ist dadurch nicht beabsichtigt.

Es zeigt
Fig. 1: eine schematische Übersicht der Erfindung und
Fig. 2: eine beispielhafte Detail- und Funktionsskizze.

Die Erfindung besteht aus einer Ausleseeinheit 1 zur zeitnahen, automatischen Erfassung und Übertragung von Daten, geeignet für private Endkunden, kommunale und mittelständische Betriebe. Die Ausleseeinheit 1 ist in ein Gesamtsystem, bestehend aus den Endgeräten 5, der Ausleseeinheit 1, dem ISDN-Telefonnetz 6, dem Erfassungsrechner 7, den Visualisierungsstationen 8 und den Netzadaptern 9 eingebunden.

Die Ausleseeinheit 1 wird beim Verbraucher, dies kann ein Energieverbraucher sein, an die vorhandene Infrastruktur angeschlossen. Die Infrastruktur kann aus verschiedenen Endgeräten 5, im einzelnen können das Gas-, Wasser-, und/oder Stromzähler sein und dem ISDN-Telefonnetz bestehen. Die Energieverbraucher (z.B. Haushalte) können hierzu mit Gas- , Wasser- und/oder Stromzählern mit integriertem Bus, (z.B. M - oder LON - Bus) oder Impulsausgängen sein, ausgerüstet werden. Die Endgeräte 5 werden über eine Bus- Leitung mit der eingangsseitigen Schnittstelle 2 der Ausleseeinheit 1 verbunden. Ausgangsseitig ist die Ausleseeinheit 1 über eine Standard - Leitung über die Schnittstelle 3 mit dem ISDN-Netz 6 verbunden. Für die Bearbeitung der eingehenden Signale und deren Umsetzung ist eine Übersetzungseinheit 4 vorgesehen, die mit der Eingangsschnittstelle 2 und der Ausgangsschnittstelle 3 verbunden ist. Die Übersetzungseinheit 4 hat die Aufgaben der Signalpegelumsetzung, der bidirektionalen Umsetzung verschiedener Protokollarten (kann M-Bus auf S₀-Bus sein), sowie der Interpretation der bidirektional ankommenden Protokolle, mit dem Ziel die für die Ausleseeinheit 1 bestimmte Information herauszufiltern und weiterzuleiten. Diese Aufgaben können durch einen programmierbaren Prozessor oder mehreren gekoppelte Prozessoren 4.1, 4.2, 4.3 realisiert werden. Hierbei kann eine Aufteilung erfolgen in den Bus Master 4.1, realisiert mit einem Zilog Baustein, die Communication Unit 4.2, realisiert mit einem Z84C90 Baustein und einem ISDN-Controller 4.3, realisiert mit Mitel Dil28 Baustein.

An die Ausleseeinheit 1 können gleichzeitig unterschiedliche Endgeräte 5 parallel über eine Bus-Leitung (oder über eine Zweidraht-Leitung) an die eingangsseitige Schnittstelle 2 angeschlossen werden. Die Daten können zeitnah automatisch über den ISDN-Anschluß ausgelesen und auf einem zentralen Rechner 7 archiviert werden. Die Visualisierung der Daten kann über das Telefonnetz 6 erfolgen. Hierzu kann der Rechner 7 im World Wide Web (WWW) angeschlossen werden. Der Endverbraucher kann dann mit einem Standardbrowser (kann zum Beispiel Netscape sein) seine Daten aufbereitet bekommen. Der Zugang erfolgt über eine spezielle Zugriffsberechtigung.

## Patentansprüche

1. Vorrichtung (1) zur automatischen Erfassung und bidirektionalen Übertragung von Daten, aufweisend eine erste Schnittstelle (2) für den Dateneingang, eine zweite Schnittstelle (3) für den Datenausgang sowie eine Übersetzungseinheit (4) zur Bearbeitung der Daten, **dadurch gekennzeichnet,**
- **daß** die erste Schnittstelle (2) ein busfähiges System ist, an das ein oder mehrere Endgeräte (5) anschließbar sind,
- däß die zweite Schnittstelle (3) eine Schnittstelle zum ISDN-Tetefonnefz (6) oder zum Kabelfernsehnetz oder zur Satelitenübertragung ist und
- **daß** die Übersetzungseinheit (4) aus mehreren programmierbaren Prozessoren (4.1, 4.2, 4.3) besteht, die so verschaltet und programmiert sind, daß die Umsetzeinheit (4) eine Datenanforderung über die zweite Schnittstelle (3) erkennen kann und eine Datenanfrage an das busfähige System (2) zur Weiterleitung an das oder jedes Endgerät (5) senden kann und eine Datenantwort von dem oder jedem Endgerät (5) über das busfähige System (2) lesen, bearbeiten und an die zweite Schnittstelle weitergeben (3) kann.

2. Vorrichtung nach Anspruch 1, **dadurch gekennzeichnet, daß** die Datenantwort das Datum, die Uhrzeit sowie eine Identifizierung des oder jedes Endgerätes (5) enthält.

3. Vorrichtung nach Anspruch 1 oder 2, **dadurch gekennzeichnet, daß** unterschiedliche Endgeräte (5) zu unterschiedlichen Zeiten ausgelesen werden können.

4. Vorrichtung nach einem oder mehreren der Ansprüche 1 bis 3, **dadurch gekennzeichnet, daß** mit der Auslesung ein Funktionstest der Endgeräte (5) gemacht werden kann.

5. Vorrichtung nach einem oder mehreren der Ansprüche 1 bis 4, **dadurch gekennzeichnet, daß** die erste Schnittstelle (2) ein M-Bus ist.

6. Vorrichtung nach einem oder mehreren der Ansprüche 1 bis 5, **dadurch gekennzeichnet, daß** die zweite Schnittstelle (3) eine RJ45 - Schnittstelle ist.

## Claims

1. Apparatus (1) for automatic acquisition and bidirectional transmission of data, having a first interface (2) for the data input, a second interface (3) for the data output and a translation unit (4) for processing the data, **characterised in that**
- the first interface (2) is a bus-capable system to which one or more terminals (5) can be connected,
- the second interface (3) is an interface to the ISDN telephone network (6) or to the cable television network or for satellite transmission, and
- the translation unit (4) comprises a plurality of programmable processors (4.1, 4.2, 4.3) which are so connected and programmed that the conversion unit (4) can detect a data request by way of the second interface (3) and can send a data inquiry to the bus-capable system (2) for forwarding. to the or each terminal (5) and can read a data response from the or each terminal (5) by way of the bus-capable system (2), process it and forward it to the second interface (3).

2. An apparatus according to claim 1 **characterised in that** the data response contains the date, the time of day and an identification of the or each terminal (5).

3. An apparatus according to claim 1 or claim 2 **characterised in that** different terminals (5) can be read out at different times.

4. An apparatus according to one or more of claims 1 to 3 **characterised in that** a function test of the terminals (5) can be performed with the reading-out operation.

5. An apparatus according to one or more of claims 1 to 4 **characterised in that** the first interface (2) is an M-bus.

6. An apparatus according to one or more of claims 1 to 5 **characterised in that** the second interface (3) is an RJ45 interface.

## Revendications

1. Dispositif (1). pour le prélèvement automatique et la transmission bidirectionnelle de données,comprenant une première interface (2) pour l'entrée de données, une deuxième interface (3) pour la sortie de données ainsi qu'une unité de traitement (3) pour le traitement des données, **caractérisé en ce que**,
- la première interface (2) est un système adaptable à un bus, qui peut être connecté à un ou plusieurs terminaux (5),
- la seconde interface (3) est une interface du réseau téléphonique ISDN (6) ou du réseau de télévision par câble ou de la transmission par satellite, et
- l'unité de traitement (4) comprend plusieurs processeurs programmables (4.1, 4.2, 4.3), qui sont montés et programmés de telle sorte que l'unité de traitement (4) peut reconnaître une requête de données de la part de la deuxième interface (3) et peut envoyer une demande de données au système périphérique (2) pour l'envoyer ensuite aux ou à chaque terminal (5) et peut lire, traiter et transmettre à la seconde interface (3) une réponse de données issue du ou de chaque terminal (5) à travers le système adaptable à un bus (2).

2. Dispositif selon la revendication 1, **caractérisé en ce que** la réponse de données contient la date, l'heure ainsi qu'une identification du ou de chaque terminal (5).

3. Dispositif selon la revendication 1 ou 2, **caractérisé en ce que** des terminaux différents (5) peuvent être lus à des moments différents.

4. Dispositif selon l'une ou plusieurs des revendications 1 à 3, **caractérisé en ce qu'**un test de fonctionnement du terminal (5) peut être effectué lors de la lecture.

5. Dispositif selon l'une ou plusieurs des revendications 1 à 4, **caractérisé en ce que** la première interface (2) est un M-Bus.

6. Dispositif selon l'une ou plusieurs des revendications 1 à 5, **caractérisé en ce que** la deuxième interface (3) est une interface RJ45.
